# EUROPEAN PATENT APPLICATION

(11) **EP 3 247 122 A1**
(43) Date of publication of application: **22.11.2017**
(21) Application number: 17159785.9
(22) Date of filing: 08.03.2017
(51) Int. Cl.: H04N 21/41, H04N 21/422, G06F 3/041

(54) **IMAGE PROCESSING TERMINAL AND METHOD FOR CONTROLLING AN EXTERNAL DEVICE USING THE SAME**

(30) Priority: 16.05.2016 KR 20160059481
(71) Applicant: Humax Co., Ltd., Yongin-si, Gyeonggi-do 17040 (KR)
(72) Inventor: PARK, Sung Heum, 16975 Yongin-si, Gyeonggi-do (KR)
(74) Representative: Zardi, Marco

(57) **Abstract**

An image processing terminal and a method for controlling an external device are disclosed. The image processing terminal comprises a receiving unit configured to receive a control signal including information about a normal input or a force input applied to a specific key of a remote controller; and a processor configured to control the image processing terminal or an external device connected to the image processing terminal according to the received control signal. Here, the processor controls an operation of the external device in response to the force input applied to the specific key of the remote controller, an operation of controlling the external device according to the force input applied to the specific key is different from an operation of controlling the image processing terminal or an operation of controlling the external device according to the normal input applied to the specific key.

## Description

### BACKGROUND

### 1. Field of the Invention

The invention relates to an image processing terminal and a method for controlling an external device using the same.

### 2. Description of the Related Art

A set-top box is connected to a television, converts properly a video signal and a voice signal received from an external device and displays an image corresponding to the converted video and voice signal through the television.

The set-top box receives an IPTV signal, a cable TV signal, a satellite TV signal or a general signal for broadcasting, and the set-top box displays the received signal on the television.

The set-top box generally interoperates with a wired or wireless controller. A user remotely controls the set-top box with the remote controller.

Functions of the set-top box or the television are diversified as types of contents and services provided from an IPTV, a cable TV or a satellite TV have been diversified. The number of buttons or keys in the remote controller controlling the set-top box or the television has increased due to the diversification of the functions.

It is preferable to provide various contents and services to the user, but the user need to know a function of each button in the remote controller in order to fully enjoy the various contents and services provided.

It becomes difficult for the user to control the remote controller with keeping the user's eyes toward the television (blind control) because the remote controller has lots of buttons or keys. Additionally, there are many factors distracting user's view when the user controls the remote controller. For example, the user should look at the remote controller and select a relevant button whenever the user wants to properly control the remote controller.

A demand for a remote controller having few or no button has been on the rise. Since a conventional remote controller does not satisfy such demand, a system and method for controlling the remote controller minimizing the number of the buttons in the remote controller is needed while allowing the user to enjoy a variety of contents and services. With the remote controller having few or no button, the user may easily figure out how to use the remote controller and it also enables the user to perform the blind control when using the remote controller.

### SUMMARY

The invention has been made to address at least the disadvantages and problems described above, and to provide at least the advantage described below. An aspect of the invention provides an image processing terminal for controlling an external device according to a sensing level corresponding to key input of a remote controller in a media system and a method for controlling the external device using the same.

According to one embodiment of the invention, an image processing terminal comprising: a receiving unit configured to receive a control signal including information about a normal input or a force input applied to a specific key of a remote controller; and a processor configured to control the image processing terminal or an external device connected to the image processing terminal according to the received control signal. Here, the processor controls an operation of the external device in response to the force input applied to the specific key of the remote controller, an operation of controlling the external device according to the force input applied to the specific key is different from an operation of controlling the image processing terminal or an operation of controlling the external device according to the normal input applied to the specific key, and the force input means an input applied the specific key of the remote controller with higher pressure or wider area than a pressure or an area in the normal input.

According to another embodiment of the invention, an image processing terminal comprising: a receiving unit configured to receive a control signal including information about a normal input or a force input applied to a specific key of a remote controller; and a processor configured to control the image processing terminal or an external device connected to the image processing terminal according to the received control signal. Here, the processor connects the image processing terminal to the external device to control the external device through the remote controller when the force input is applied to the specific key of the remote controller, controls an operation of the external device in response to the force input applied to the specific key or a normal input or a force input applied to a key other than the specific key while the image processing terminal is connected to the external device, and the force input means an input applied the specific key of the remote controller with higher pressure or wider area than a pressure or an area in the normal input.

According to still another embodiment of the invention, an image processing terminal comprising: a receiving unit configured to receive a control signal including information about a normal input or a force input applied to a specific key of a remote controller; and a processor configured to control the image processing terminal or an external device connected to the image processing terminal according to the received control signal. Here, the processor controls the external device in response to a force input applied to a first key of the remote controller, executes a preset operation of the image processing terminal in response to a normal input or a force input applied to a second key of the remote controller different from the first key, and the force input means an input applied the specific key of the remote controller with higher pressure or wider area than a pressure or an area in the normal input.

According to one embodiment of the invention, a method for controlling an external device in an image processing terminal, the method comprising: receiving a control signal including information about a normal input or a force input applied to a specific key of a remote controller; and controlling the image processing terminal or the external device connected to the image processing terminal in response to the received control signal. Here, an operation of the external device is controlled in response to the force input applied to the specific key of the remote controller, the operation of the external device in response to the force input applied to the specific key is different from an operation of the image processing terminal or the external device in response to the normal input applied to the specific key, and the force input means an input applied the specific key of the remote controller with higher pressure or wider area than a pressure or an area in the normal input.

The invention provides an image processing terminal and a method for controlling an external device using the same. The image processing terminal and the method may control the external device according to a force input of a remote controller.

Thus, a user may control the external device through the remote controller while he is viewing a television, thereby enhancing user's convenience.

### BRIEF DESCRIPTION OF DRAWINGS

The aspects, features, advantages and embodiments of the invention will be more apparent from the following detailed description taken in conjunction with reference to the accompanying drawings, in which:
FIG. 1 is a view illustrating a media system according to one embodiment of the invention;
FIG. 2 is a view illustrating schematically a remote controller according to one embodiment of the invention;
FIG. 3A to FIG. 3C are views illustrating a normal input and a force input according to one embodiment of the invention;
FIG. 4 is a view illustrating a sensing level corresponding to the normal input and the force input according to one embodiment of the invention;
FIG. 5 is a flowchart illustrating schematically an operation of a media system according to one embodiment of the invention;
FIG. 6 is a flowchart illustrating a method for controlling an external device in an image processing terminal according to one embodiment of the invention;
FIG. 7 is a flowchart illustrating a method of controlling the external device in the image processing terminal according to another embodiment of the invention;
FIG. 8A, FIG. 8B, FIG. 9A and FIG. 9B are views illustrating visually control of the external device according to another embodiment of the invention;
FIG. 10A and FIG. 10B are views illustrating a method for controlling the external device by the image processing terminal according to still another embodiment of the invention;
FIG. 11A and FIG. 11B are views illustrating an image processing terminal according to still another embodiment of the invention;
FIG. 12A and FIG. 12B are views illustrating visually a sensing level in the image processing terminal according to one embodiment of the invention; and
FIG. 13 is a view illustrating schematically the image processing terminal according to one embodiment of the invention.

### DETAILED DESCRIPTION

In the present specification, an expression used in the singular encompasses the expression of the plural unless it has a clearly different meaning in the context. In the present specification, terms such as "comprising" or "including," etc., should not be interpreted as meaning that all of the elements or operations are necessarily included. That is, some of the elements or operations may not be included, while other additional elements or operations may be further included. Also, terms such as "unit," "module," etc., as used in the present specification may refer to a part for processing at least one function or action and may be implemented as hardware, software, or a combination of hardware and software.

The invention relates to a media system including an image processing terminal and a remote controller for controlling the same. Here, the image processing terminal may be a display device, including a television, for displaying visually information or a set-top box for transmitting a variety of information to the display device. The image processing terminal is not limited as a specific device as long as it is a device for visually outputting data. For example, the image processing terminal may be the set-top box or the television having functions of the set-top box.

The remote controller of the invention includes at least one key, and provides a control signal including information about a sensing level of a key selected by a user to the image processing terminal. In this case, the image processing terminal may perform different functions or screens according to the sensing level of the key. Here, the key of the remote controller may be implemented by hardware including dome key type, or implemented by software.

Hereinafter, various embodiments of the invention will be described in detail with reference to accompanying drawings.

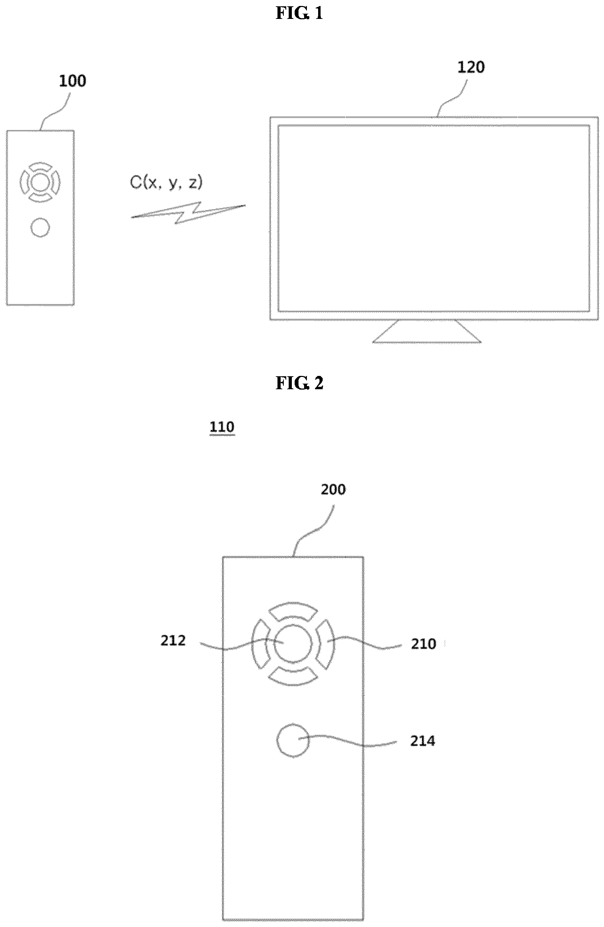

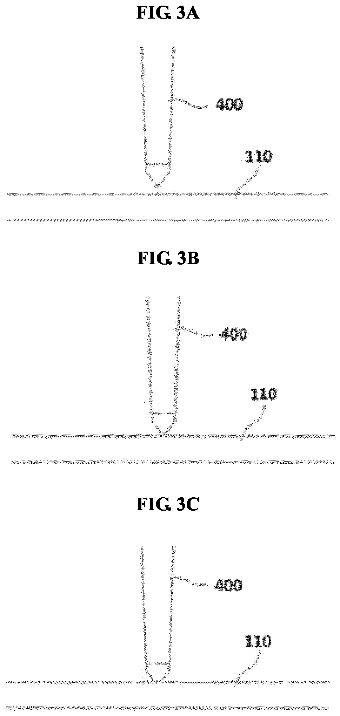

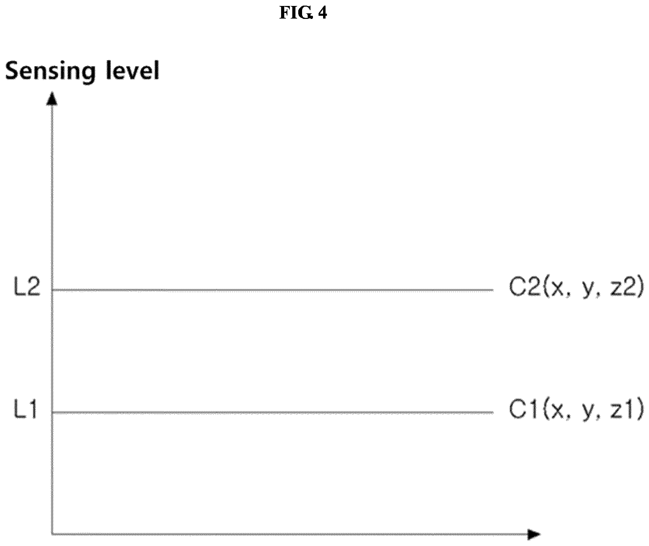

FIG. 1 is a view illustrating a media system according to one embodiment of the invention, and FIG. 2 is a view illustrating schematically a remote controller according to one embodiment of the invention. FIG. 3A to FIG. 3C are views illustrating a normal input and a force input according to one embodiment of the invention, and FIG. 4 is a view illustrating a sensing level corresponding to the normal input and the force input according to one embodiment of the invention.

In FIG. 1, the media system of the present embodiment includes a remote controller 100 and an image processing terminal 120. The image processing terminal 120 is connected to one or more external devices via a home network.

The remote controller 100 transmits a control signal in response to an input to a key by a user to the image processing terminal 120.

FIG. 2 shows an external appearance of the remote controller 100 according to the invention. In FIG. 2, the remote controller 100 may include a body 200 and a plurality of keys formed on the body 200. Here, the keys formed on the body 200 may include a navigation key 210 including up, down, left, or right directional keys, a function key 214 for performing a variety of operations such as an esc key and a home key, etc., and a decision key 212 for performing an operation of an OK key, etc. Of course, various keys other than the navigation key 210, the decision key 212 and the function key 214 may exist in the remote controller 100. The various keys may be classified as the navigation key 210, the decision key 212 and the function key 214.

The remote controller 100 according to the invention supports plural inputs about one key. More specifically, the remote controller 100 provides a normal input and a force input about one or more keys of keys therein.

Here, the normal input means a general input pressed or touched by a user. For example, the normal input may be an input when a touch means 400 touches a specific key of the remote controller 100 as shown in FIG. 3B, under the condition that the touch means 300 does not touch the specific key of the remote controller 100 as shown in FIG. 3A.

The force input means an input to the key when the key is pressed or touched with higher pressure or a wider area than those of the normal input. The force input may be an input applied to the key as shown in FIG. 3C when the key is continuously touched or pressed with higher pressure or wider area after the touch means 400 touches or presses the key as shown in FIG. 3B under the condition that the touch means 400 does not touch or press a specific key as shown in FIG. 3A.

The sensing level differs according to the normal input or the force input though the user touches or presses the same key. As a result, the remote controller 100 may transmit different control signals to the image processing terminal 120 in response to the sensing level corresponding to the normal input or the force input, as shown in FIG. 4.

That is, the remote controller 100 may transmit different control signals to the image processing terminal 120 when the user applies the normal input to one key or when the user applies the force input to the one key. Accordingly, functions related to plural operations of the image processing terminal 120 may be set to at least one of the keys of the remote controller 100.

For example, the remote controller 100 may transmit different control signals to the image processing terminal 120 in response to the pressure or the area applied to a specific key of the remote controller 100 by using the touch means 400 such as a finger. Particularly, the remote controller 100 may transmit a first control signal including information concerning a specific key and a first sensing level corresponding to the normal input to the image processing terminal 120, when the user applies the normal input to the specific key of the remote controller 100. The remote controller 100 may transmit a second control signal including the information concerning the specific key and a second sensing level corresponding to the force input to the image processing terminal 120, when the user applies the force input to the specific key of the remote controller 100.

As a result, the image processing terminal 120 may perform different operations/functions according to the normal input or the force input, though the user touches or presses the same key.

As described above, the remote controller 100 may transmit the control signal including information concerning the specific key selected by the user and the sensing level corresponding to the pressure or the area applied to the specific key to the image processing terminal 120.

In one embodiment, the remote controller 100 may transmit the control signal including coordinate information to the image processing terminal 120.

For example, the information concerning the specific key selected by the user may be included in the control signal where it is expressed in a coordinate (x, y). The sensing level may be included in the control signal where it is expressed in a coordinate (z). That is, the remote controller 100 may transmit the control signal including a coordinate (x, y, z) to the image processing terminal 120.

Accordingly, the remote controller 100 may transmit a first control signal C1 including a coordinate (x, y, z1) to the image processing terminal 120, when the user presses or touches the specific key of the remote controller 100 with a first sensing level. The remote controller 100 may transmit a second control signal C2 including a coordinate (x, y, z2) to the image processing terminal 120, when the user presses or touches the specific key of the remote controller 100 with a second sensing level.

As a result, the image processing terminal 120 may perform different operations according to the sensing level, even if the user presses or touches the same key.

For example, the image processing terminal 120 may control its internal function in response to the first sensing level, when the specific key of the remote controller 100 is pressed or touched with the first sensing level (i.e. when the sensing level included in the control signal is the sensing level corresponding to the normal input).

The image processing terminal 120 may control an external device in response to the second sensing level, when the sensing level is the second sensing level corresponding to the force input. As mentioned above, the image processing terminal 120 may be connected to one or more external devices through the home network.

Accordingly, the image processing terminal 120 may control the external device when the force input is applied to the specific key of the remote controller 100. That is, the image processing terminal 120 may transmit a control command for controlling the external device to the external device depending on key information corresponding to the applied force input, thereby controlling the external device.

For example, it is assumed that the external device connected to the image processing terminal 120 through the home network is a lighting device. In the event that a control function of the lighting device is set to be matched with the force input applied to an up key and a down key of the remote controller 100, the image processing terminal 120 may control to turn on the lighting device when the force input is applied to the up key of the remote controller 100. Whereas, the image processing terminal 120 may control to turn off the lighting device when the force input is applied to the down key of the remote controller 100.

For another example, the image processing terminal 120 may change illumination of the lighting device according to the sensing level. For example, the image processing terminal 120 may control to increase the illumination of the lighting device in the event that the force input is applied to a left key of the remote controller 100. Whereas, the image processing terminal 120 may control to decrease the illumination of the lighting device in the event that the force input is applied to a right key of the remote controller 100.

For still another example, a plurality of external devices may be set to be matched with corresponding key while the external devices are connected to the image processing terminal 120 through the home network. In the event that the force input is applied to a specific key, the image processing terminal 120 may control an external device corresponding to the specific key in response to a control of the remote controller 100 after the force input is applied.

The user may register a specific key of exclusive remote controller for the image processing terminal 120 as a shortcut key while the external device, such as the lighting device, a gas circuit breaker, an air conditioner, an air cleaner, etc., is connected to the image processing terminal 120 through the home network. In this case, the user may select an external device to be controlled via the image processing terminal 120 by applying the force input to an designated key of the remote controller 100 corresponding to the external device, and then control the selected external device in response to a control of the key of the remote controller 100. Accordingly, the user need not to inconveniently control plural remote controllers, and may control the external device without actual moving while he is watching a television, etc. As a result, user's convenience may be enhanced.

For still another example, the image processing terminal 120 may perform different functions according to the sensing level depending on an input to a specific key of the remote controller 100. That is, the image processing terminal 120 may perform different operations according to whether the input applied to the specific key of the remote controller 100 corresponds to the normal input or the force input. For example, the image processing terminal 120 may output a program guide when the normal input is applied to the specific key, and output a VOD list when the force input is applied to the specific key.

In above embodiments, the sensing level corresponds to the pressure or the area applied to the key, but it may correspond to combination of plural information.

That is, the remote controller 100 may transmit a control signal including a sensing level corresponding to the pressure applied to the specific key by the user and a sensing level corresponding to the area applied to the specific key by the user to the image processing terminal 120. As a result, the control signal may be expressed in four dimensional coordinate (x, y, z, t).

In brief, one or more parameters may be set for the sensing level included in the control signal in accordance with a control of the key of the remote controller 100.

The remote controller 100 of the invention may control the image processing terminal 120 or the external device according to the sensing level of the specific key.

In the conventional remote controller, an input to the key includes only the normal input. As a result, only one operation is matched with one key, and thus the remote controller should include many keys. Accordingly, the remote controller has become complicated and caused inconvenience to users.

Whereas, the remote controller 100 of the invention provides different sensing levels corresponding to the normal input and the force input, and thus a plurality of operations not one operation may be matched with one key.

As a result, the remote controller 100 of the invention may have few or no key compared with the conventional remote controller, and so the structure of the remote controller 100 of the invention is simpler than that of the conventional remote controller. Accordingly, user's visibility is enhanced and user's convenience may be enhanced in controlling the remote controller 100.

Additionally, the remote controller 100 transmits the control signal including the coordinate information having key information in accordance with the input to the specific key and the sensing level to the image processing terminal 120. In this case, the image processing terminal 120 may perform different operations according to software installed therein, even if the remote controller 100 transmits the same coordinate information to the image processing terminal 120.

Now referring to FIG. 1, the image processing terminal 120 is connected to at least one of the external devices through the home network. The image processing terminal 120 may control its internal operation or the external device according to the sensing level of the remote controller 100 which is connected to the image processing terminal 120 through the wireless communication.

Hereinafter, this will be described in detail with reference to accompanying drawings.

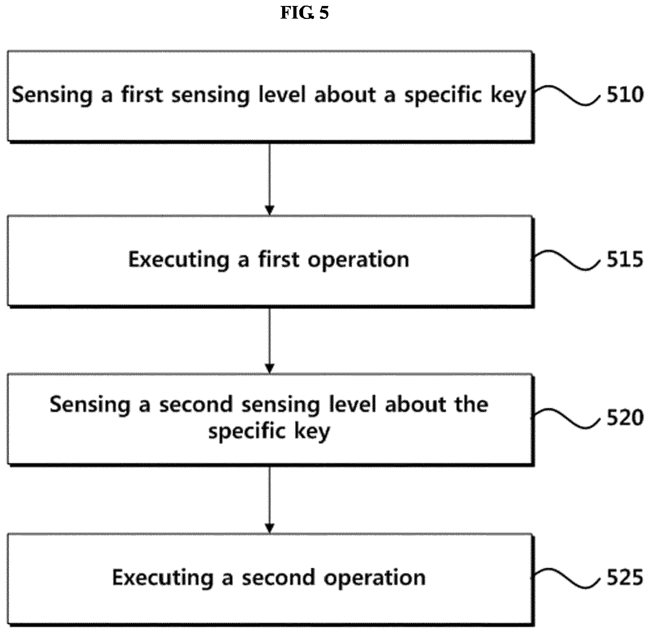

FIG. 5 is a flowchart illustrating schematically an operation of a media system according to one embodiment of the invention.

In a step of 510, the remote controller 100 transmits a first control signal C(x, y, z1) including key information and a first sensing level in accordance with a normal input applied to a specific key to the image processing terminal 120, when the user applies the normal input to the specific key of the remote controller 100.

As described above, the sensing level differs according to whether the input applied to the key of the remote controller 100 corresponds to the normal input or the force input. Accordingly, the remote controller 100 may transmit the control signal including the sensing level to the image processing terminal 120, the sensing level differing depending on at least one of the pressure or the area applied to the key though the user touches or presses the same key.

In a step of 515, the image processing terminal 120 may control its internal operation in response to the transmitted first control signal.

In a step of 520, the remote controller 100 transmits a second control signal C(x, y, z2) including key information and a second sensing level to the image processing terminal 120, in the event that the user touches or presses the specific key with higher pressure or wider area.

In a step of 525, the image processing terminal 120 may control the external device in response to the transmitted second control signal.

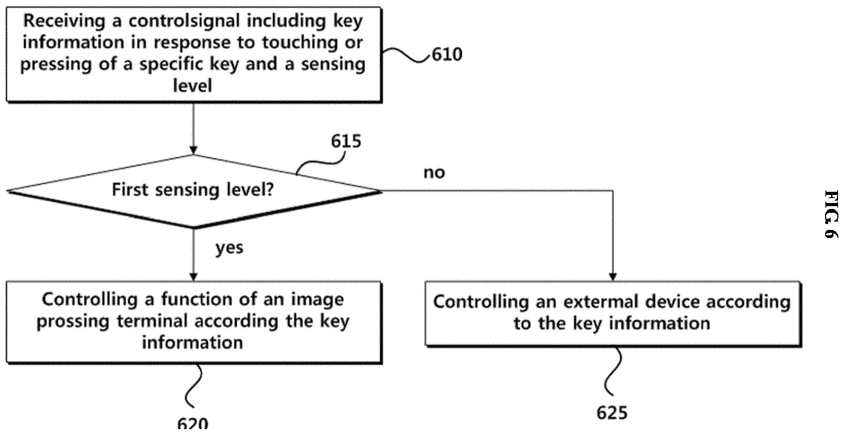

FIG. 6 is a flowchart illustrating a method for controlling an external device in an image processing terminal according to one embodiment of the invention. Hereinafter, it is assumed that the image processing terminal 120 is connected to one or more external devices via a home network.

In a step of 610, the image processing terminal 120 receives a control signal including key information in response to touching or pressing of a specific key and a sensing level from the remote controller 100.

Here, the sensing level differs depending on at least one of a pressure or an area applied to the specific key. That is, the sensing level may differ according as a user applies the normal input or the force input to the specific key of the remote controller 100.

The control signal may include three or more dimensional coordinate information. First axis coordinate information (e.g. x-axis coordinate information) and second axis coordinate information (e.g. y-axis coordinate information) of the coordinate information may be a coordinate of the specific key pressed or touched by the user. z-axis coordinate information of the coordinate information may be information concerning the sensing level.

In a step of 615, the image processing terminal 120 determines whether the sensing level of the control signal corresponds to a first sensing level or a second sensing level.

In a step of 620, in the event that the sensing level corresponds to the first sensing level, the image processing terminal 120 determinates that the normal input is applied to the specific key of the remote controller 100, and thus it controls its internal operation according to the key information.

In a step of 625, in the event that the sensing level corresponds to the second sensing level, the image processing terminal 120 determines that the force input is applied to the specific key of the remote controller 100, and so it may control the external device according to the key information.

For example, in the event that the normal input is applied to an up key of the remote controller 100, the image processing terminal 120 may search upward a channel list, a program list or a VOD list and change an entity in the list. In the event that the force input is applied to the up key of the remote controller 100, the image processing terminal 120 may turn on a power of a lighting device connected thereto through the home network.

In the event that the normal input is applied to a down key of the remote controller 100, the image processing terminal 120 may search downward the channel list, the program list or the VOD list and change an entity in the list. In the event that the force input is applied to the down key of the remote controller 100, the image processing terminal 120 may turn off the power of the lighting device connected thereto through the home network.

In another embodiment, in the event that the force input is applied to the up key of the remote controller 100, the image processing terminal 120 may increase illumination of the lighting device. Here, the image processing terminal 120 may increase step by step the illumination of the lighting device according to a number or a time of the force input applied to the up key of the remote controller 100. Additionally, in the event that the force input is applied to the down key of the remote controller 100, the image processing terminal 120 may decrease the illumination of the lighting device. The image processing terminal 120 may decrease step by step the illumination of the lighting device according to a number or a time of the force input applied to the down key.

In the normal input and the force input applied to the specific key of the remote controller 100, the image processing terminal 120 may determine corresponding sensing level as the sensing level in response to the input applied to the specific key of the remote controller 100 if the corresponding sensing level is not changed during predetermined period of time.

In the event that the force input is applied to the specific key of the remote controller 100, an input to the specific key may be changed to the force input after the normal input. Accordingly, the image processing terminal 120 may determine the corresponding sensing level as the sensing level in response to the input applied to the specific key when the corresponding sensing level is not changed during the predetermined period of time.

In still another embodiment, the image processing terminal 120 may be connected to the external device so that the external device is controlled thereby when the force input is applied to the specific key of the remote controller 100. Subsequently, the image processing terminal 120 may control an operation of the external device when the force input is again applied to the specific key or a normal input or a force input is applied to a key other than the specific key, under the condition that it is connected to the external device.

In this case, information concerning control of the external device may be internally set to the image processing terminal 120. The image processing terminal 120 may delete the information concerning the control of the external device when preset period of time elapses or the normal input or the force input is applied to the specific key.

In still another embodiment, the image processing terminal 120 may recognize a control signal transmitted from the remote controller 100 as a control signal for the external device when the force input is applied to the specific key of the remote controller 100, and it may deliver the control signal to the external device. Here, the control signal may include the coordinate information about the specific key and the sensing level.

Accordingly, the external device may extract the coordinate information of the specific key and the sensing level from the control signal received from the image processing terminal 120, generate a control command for its control in response to the extracted coordinate information and the extracted sensing level, and then control its internal operation using the generated control command.

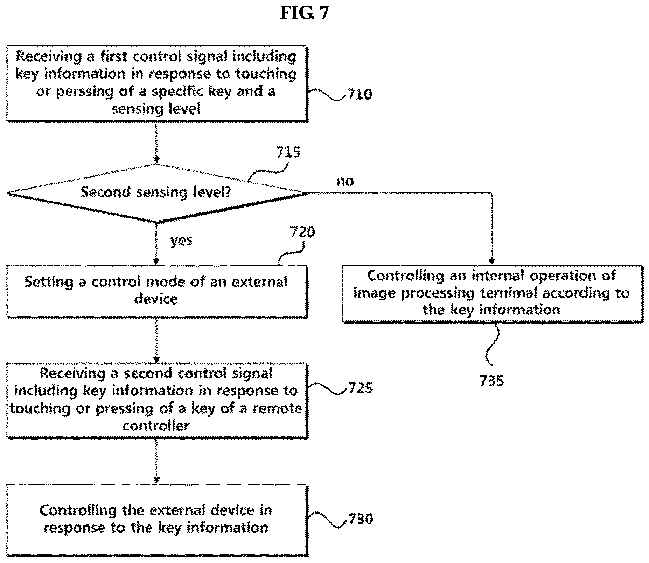

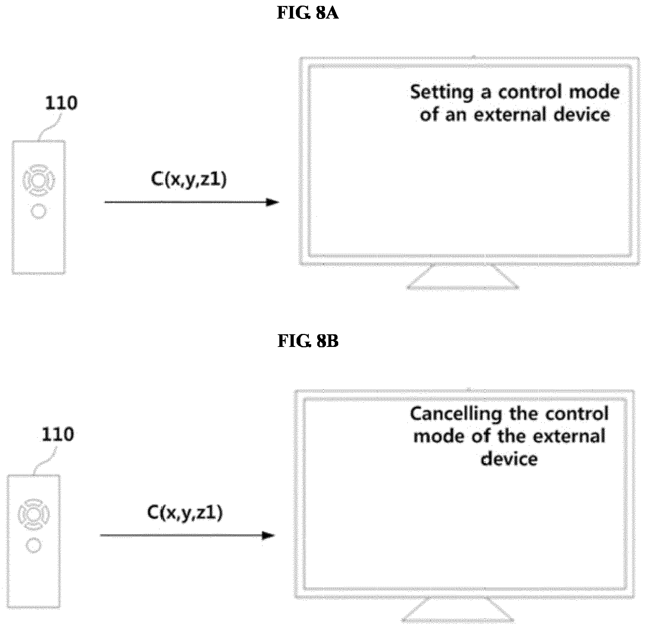

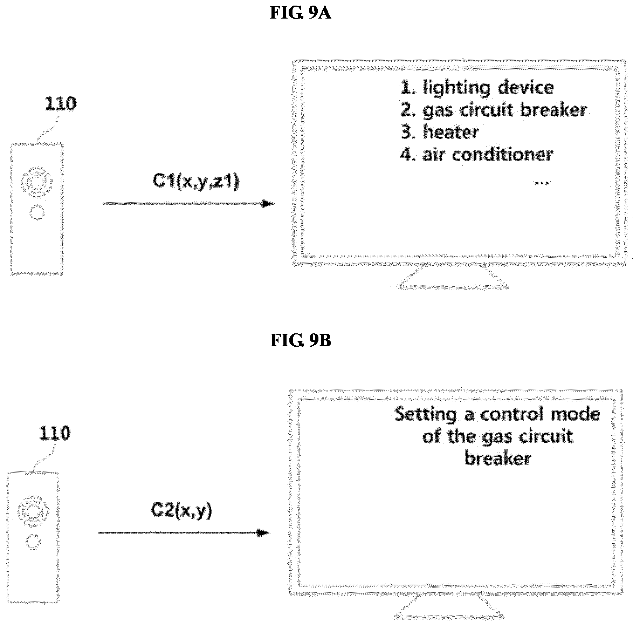

FIG. 7 is a flowchart illustrating a method of controlling the external device in the image processing terminal according to another embodiment of the invention, and FIG. 8A, FIG. 8B, FIG. 9A and FIG. 9B are views illustrating visually control of the external device according to another embodiment of the invention.

In a step of 710, the image processing terminal 120 receives a first control signal from the remote controller 100, the first signal including key information in response to touching or pressing of a specific key of the remote controller 100 and a sensing level in accordance with at least one of a pressure or an area applied to the specific key.

In a step of 715, the image processing terminal 120 determines whether the sensing level included in the first control signal corresponds to a second sensing level.

That is, the image processing terminal 120 determines whether or not the force input is applied to the specific key.

In a step of 720, in the event that the sensing level of the specific key corresponds to the second sensing level, the image processing terminal 120 sets a control mode of the external device.

In the event that the control mode of the external device is set, the image processing terminal 120 determines a signal received in response to touching or pressing of the key of the remote controller 100 as a signal for control of the external device. The signal received from the remote controller 100 after the control mode of the external device is set may not include the sensing level.

In a step of 725, the image processing terminal 120 receives a second control signal in response to touching or pressing of the key of the remote controller 100. Here, the second control signal may include only key information in response to the touching or pressing of the key of the remote controller 100.

In a step of 730, the image processing terminal 120 controls the external device according to the second control signal.

However, in a step of 735, in the event that the sensing level included in the first control signal corresponds to the first sensing level, the image processing terminal 120 may control its internal operation according to the key information included in the first control signal.

The control mode of the external device may be automatically cancelled when a predetermined period of time elapses after the control mode of the external device is set to the image processing terminal 120, which is not shown in FIG. 7. That is, the image processing terminal 120 may cancel automatically the control mode when the predetermined period of time elapses after setting temporarily the remote controller 100 as an exclusive device for control of the external device through the touching or pressing of the specific key of the remote controller 100. Thus, the remote controller 100 may normally use the remote controller 100 as a device for control of the internal operation of the image processing terminal 120.

In another embodiment, the image processing terminal 120 may cancel the control mode of the external device when the force input is again applied to the specific key touched or pressed for setting to the control mode of the external device.

For example, in the event that the force input is applied to a home key of the remote controller 100, the image processing terminal 120 may temporarily set the control mode of the external device (FIG. 8A). Subsequently, the image processing terminal 120 may control the external device according to the touching or pressing of the key of the remote controller 100.

Subsequently, in the event that the force input is again applied to the home key of the remote controller 100, the image processing terminal 120 may cancel the set control mode of the external device (FIG. 8B). As a result, the image processing terminal 120 may control its internal operation according to the touching or pressing of the key of the remote controller 100.

In still another embodiment, it is assumed that the image processing terminal 120 is connected to a plurality of external devices. In the event that the force input is applied to the home key of the remote controller 100, the image processing terminal 120 may output an external device list so that the user can select the external device. The user may select any one of entities in the external device list through the remote controller 100.

Subsequently, the image processing terminal 120 may temporarily set the control mode to a control mode of the selected external device (that is, control mode of the external device to be controlled).

Accordingly, the image processing terminal 120 may control the external device to be controlled in response to other key, when the user touches or presses the other key (e.g. an up key, a down key, a right key, a left key, etc.) of the remote controller 100.

For example, it is assumed that the image processing terminal 120 is connected to the external devices, such as a gas circuit breaker, a lighting device, a heater, an air conditioner, etc., via the home network. In the event that the force input is applied to a specific key (e.g. a home key) set for controlling the external device of the remote controller 100, the image processing terminal 120 may output the external device list including the gas circuit breaker, the lighting device, the heater and the air conditioner(FIG. 9A). The user may select any one of the gas circuit breaker, the lighting device, the heater and the air conditioner through the remote controller 100, and then temporarily set the control mode of the external device to be controlled (FIG. 9B).

The image processing terminal 120 may internally set a control mode of the gas circuit breaker, when the user selects the gas circuit breaker through the remote controller 100. Subsequently, when the user touches or presses a right key of the remote controller 100 to activate gas, the image processing terminal 120 may activate the gas by controlling the gas circuit breaker. In the event that the user touches or presses a down key of the remote controller 100 to reduce the gas, the image processing terminal 120 may control the gas circuit breaker to reduce the gas.

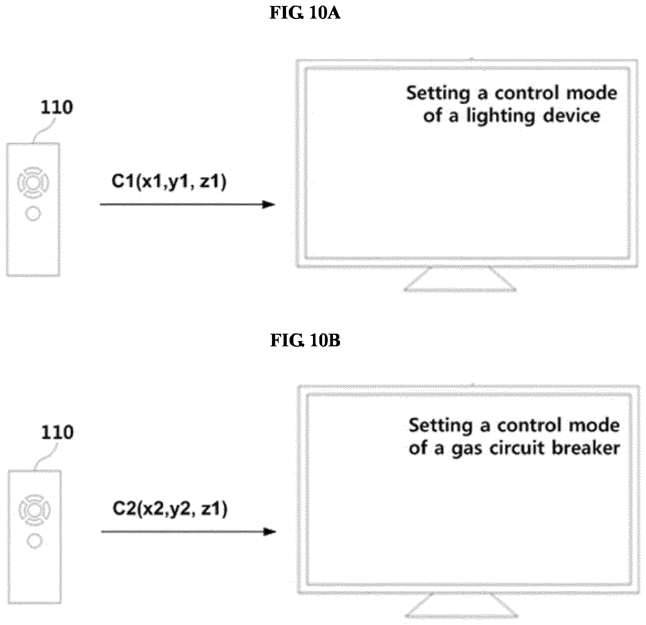

FIG. 10A and FIG. 10B are views illustrating a method for controlling the external device by the image processing terminal according to still another embodiment of the invention.

The external devices may be respectively set about the force input applied to the specific key of the remote controller 100 like a method for setting a shortcut.

For example, in the event that the force input is applied to the home key of the remote controller 100, the image processing terminal 120 may internally set the control mode to a control mode of the lighting device according to the force input to the home key. In this case, the image processing terminal 120 may turn on or off the lighting device as shown in FIG. 10A in response to a control of the remote controller 100. The image processing terminal 120 may also increase or decrease step by step the illumination of the lighting device.

In the event that the force input is applied to the ok key of the remote controller 100, the image processing terminal 120 may set the control mode to a control mode of the gas circuit breaker. In this case, the image processing terminal 120 may activate or inactivate the gas by turning on or off the gas circuit breaker as shown in FIG. 10B in response to a control of the remote controller 100. The image processing terminal 120 may also increase or decrease step by step a pressure of the gas.

In the event that the external device to be controlled is selected according to the force input applied to the specific key of the remote controller 100 like a method for selecting the shortcut key, the image processing terminal 120 may automatically cancel the control mode of the external device when a predetermined period of time elapses or no input is applied to the remote controller 100 during a preset period of time.

The image processing terminal 120 may visually output the control mode according to a control the remote controller 100 as shown in FIG. 10A and FIG. 10B, to easily identify the external device to be controlled.

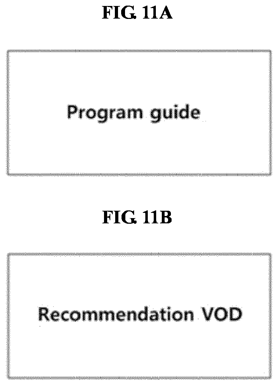

FIG. 11A and FIG. 11B are views illustrating an image processing terminal according to still another embodiment of the invention.

As shown in FIG. 11A and FIG. 11B, the image processing terminal 120 may perform different operations (functions) according to the sensing level corresponding to the normal input or the force input applied to a specific key of the remote controller 100.

For example, the image processing terminal 120 may output a program guide as shown in FIG. 11A, when the normal input is applied to the specific key of the remote controller 100.

The image processing terminal 120 may output a VOD list as shown in FIG. 11B, when the force input is applied to the specific key of the remote controller 100.

A plurality of functions may be set to one key of the remote controller 100, and thus the remote controller 100 need not to have unnecessarily many numbers of keys. As a result, user's visibility may be enhanced.

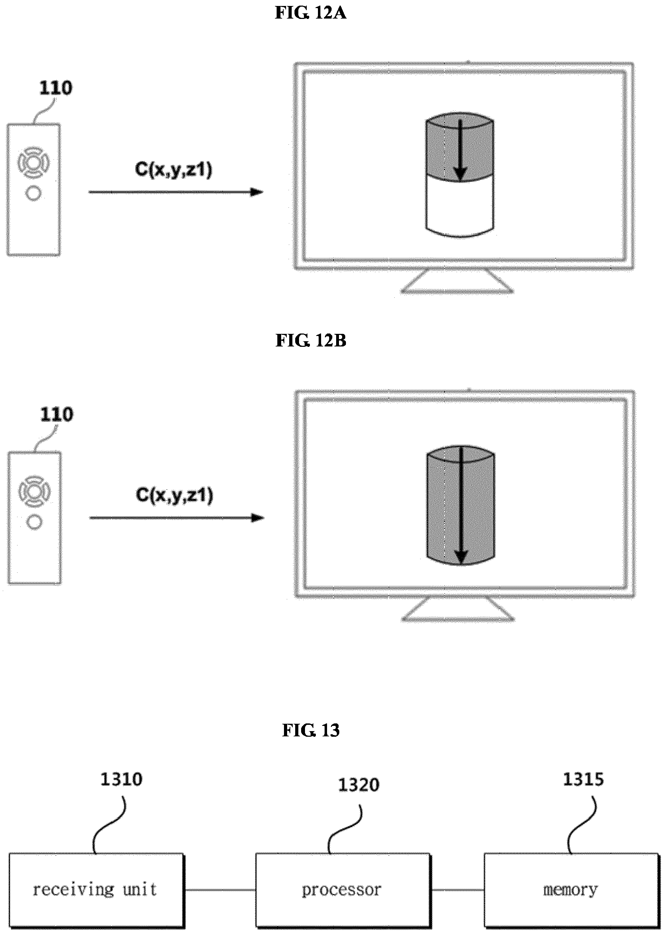

FIG. 12A and FIG. 12B are views illustrating visually a sensing level in the image processing terminal according to one embodiment of the invention.

As described above, if the remote controller 100 supports the normal input and the force input about its specific key, it may be difficult for the user to recognize accurately whether the normal input or the force input is applied to the specific key of the remote controller 100.

Accordingly, the image processing terminal 120 may output change of the sensing level with visual difference as shown in FIG. 12A and FIG. 12B when the user controls the remote controller 100, if the normal input and the force input are supported.

FIG. 12A shows outputting visually the normal input to the specific key of the remote controller 100 by the user, and FIG. 12B illustrates outputting visually the force input to the specific key of the remote controller 100.

In FIG. 12A and FIG. 12B, the change of the sensing level is outputted with visual difference, and thus the user can easily recognize whether he applies the normal input or the force input to the specific key of the remote controller 100.

FIG. 13 is a view illustrating schematically the image processing terminal according to one embodiment of the invention.

In FIG. 13, the image processing terminal 120 of the present embodiment includes a receiving unit 1310, a memory 1315 and a processor 1320.

The receiving unit 1310 receives the control signal including the key information in response to the touching or pressing of a specific key of the remote controller 100 and the sensing level corresponding to at least one of the pressure or the area applied to the specific key.

The memory 1315 stores a variety of applications, algorithms, etc. needed for controlling the external device according to the sensing level corresponding to the touching or pressing of the specific key of the remote controller 100.

The processor 1320 controls elements (e.g. the receiving unit 1310, the memory 1315, etc.) of the image processing terminal 120.

The processor 1320 may control the internal operation of the image processing terminal 120 or the external device according to the key information and the sensing level included in the control signal.

For example, the processor 1320 may control the internal operation of the image processing terminal 120 according to the key information, when the sensing level included in the control signal is a first sensing level corresponding to the normal input. The processor 1320 may control the external device according to the key information, when the sensing level included in the control signal is a second sensing level corresponding to the force input.

For another example, in the event that a plurality of external devices are connected to the image processing terminal 120, the processor 1320 may control the external device corresponding to a specific key when the force input is applied to the specific key of the remote controller 100.

As described above, the processor 1320 may control the external device or the internal operation of the image processing terminal 120 according to the sensing level corresponding to the normal input or the force input applied to the specific key of the remote controller 100. Here, the sensing level may be changed in a certain period of time. Accordingly, the processor 1320 may determine corresponding sensing level as the sensing level about the specific key, when the corresponding sensing level is not changed continuously during a predetermined period of time.

Components in the embodiments described above can be easily understood from the perspective of processes. That is, each component can also be understood as an individual process. Likewise, processes in the embodiments described above can be easily understood from the perspective of components.

Also, the technical features described above can be implemented in the form of program instructions that may be performed using various computer means and can be recorded in a computer-readable medium. Such a computer-readable medium can include program instructions, data files, data structures, etc., alone or in combination. The program instructions recorded on the medium can be designed and configured specifically for the invention or can be a type of medium known to and used by the skilled person in the field of computer software. Examples of a computer-readable medium may include magnetic media such as hard disks, floppy disks, magnetic tapes, etc., optical media such as CD-ROM's, DVD's, etc., magneto-optical media such as floptical disks, etc., and hardware devices such as ROM, RAM, flash memory, etc. Examples of the program of instructions may include not only machine language codes produced by a compiler but also high-level language codes that can be executed by a computer through the use of an interpreter, etc. The hardware mentioned above can be made to operate as one or more software modules that perform the actions of the embodiments of the invention, and vice versa.

The embodiments of the invention described above are disclosed only for illustrative purposes. A person having ordinary skill in the art would be able to make various modifications, alterations, and additions without departing from the spirit and scope of the invention, but it is to be appreciated that such modifications, alterations, and additions are encompassed by the scope of claims set forth below.

### [Description of reference numbers]

- 100 :: remote controller
- 120 :: image processing terminal

## Claims

1. An image processing terminal comprising:
a receiving unit configured to receive a control signal including information about a normal input or a force input applied to a specific key of a remote controller; and
a processor configured to control the image processing terminal or an external device connected to the image processing terminal according to the received control signal,
wherein the processor controls an operation of the external device in response to the force input applied to the specific key of the remote controller, an operation of controlling the external device according to the force input applied to the specific key is different from an operation of controlling the image processing terminal or an operation of controlling the external device according to the normal input applied to the specific key, and
the force input means an input applied the specific key of the remote controller with higher pressure or wider area than a pressure or an area in the normal input.

2. The image processing terminal of claim 1, wherein the processor controls an operation of a first external device when the force input is applied to the specific key with a first level, and controls an operation of a second external device when the force input is applied to the specific key with a second level.

3. The image processing terminal of claim 1, wherein the processor outputs a list including a plurality of external devices connected to the image processing terminal according to the force input, receives information about an external device to be controlled selected from the list through the remote controller, and controls the external device to be controlled depending on a key to which the force input is applied.

4. The image processing terminal of claim 1, wherein the control signal includes three or more dimensional coordinate information,
and wherein the processor determines the normal input or the force input by using the three or more dimensional coordinate information.

5. The image processing terminal of claim 1, wherein the processor visually outputs information concerning a change of an external device to be controlled according to the force input.

6. An image processing terminal comprising:
a receiving unit configured to receive a control signal including information about a normal input or a force input applied to a specific key of a remote controller; and
a processor configured to control the image processing terminal or an external device connected to the image processing terminal according to the received control signal,
wherein the processor connects the image processing terminal to the external device to control the external device through the remote controller when the force input is applied to the specific key of the remote controller, controls an operation of the external device in response to the force input applied to the specific key or a normal input or a force input applied to a key other than the specific key while the image processing terminal is connected to the external device, and
the force input means an input applied the specific key of the remote controller with higher pressure or wider area than a pressure or an area in the normal input.

7. The image processing terminal of claim 6, wherein the processor outputs a list including a plurality of external devices connected to the image processing terminal according to a force input applied to a first key, receives information about an external device selected from the list through the remote controller, and controls an operation of the selected external device according to a force input or a normal input applied to a second key.

8. The image processing terminal of claim 7, wherein the processor deletes a setting about the selection of the external device when a predetermined period of time elapses after controlling the operation of the external device.

9. The image processing terminal of claim 7, wherein the processor visually outputs information concerning a selection of a changed another external device to be controlled when the external device to be controlled is changed to another external device in the list, by a control of the remote controller.

10. An image processing terminal comprising:
a receiving unit configured to receive a control signal including information about a normal input or a force input applied to a specific key of a remote controller; and
a processor configured to control the image processing terminal or an external device connected to the image processing terminal according to the received control signal,
wherein the processor controls the external device in response to a force input applied to a first key of the remote controller, executes a preset operation of the image processing terminal in response to a normal input or a force input applied to a second key of the remote controller different from the first key, and
the force input means an input applied the specific key of the remote controller with higher pressure or wider area than a pressure or an area in the normal input.

11. The image processing terminal of claim 10, wherein the processor controls a first external device when the force input is applied to the first key with a first level, and controls a second external device when the force input is applied to the first key with a second level.

12. A method for controlling an external device in an image processing terminal, the method comprising:
receiving a control signal including information about a normal input or a force input applied to a specific key of a remote controller; and
controlling the image processing terminal or the external device connected to the image processing terminal in response to the received control signal,
wherein an operation of the external device is controlled in response to the force input applied to the specific key of the remote controller, the operation of the external device in response to the force input applied to the specific key is different from an operation of the image processing terminal or the external device in response to the normal input applied to the specific key, and
the force input means an input applied the specific key of the remote controller with higher pressure or wider area than a pressure or an area in the normal input.
